# EUROPEAN PATENT SPECIFICATION

(11) **EP 3 758 059 B1**
(45) Date of publication and mention of the grant of the patent: **27.05.2026**
(21) Application number: 19183284.9
(22) Date of filing: 28.06.2019
(51) Int. Cl.: H01L 23/473, H05K 7/20

(54) **POWER INVERTER DEVICE, ARRANGEMENT AND CORRESPONDING OPERATING METHOD**
WECHSELRICHTERVORRICHTUNG, ANORDNUNG UND ENTSPRECHENDES BETRIEBSVERFAHREN
DISPOSITIF ONDULEUR DE PUISSANCE, AGENCEMENT ET PROCÉDÉ DE FONCTIONNEMENT CORRESPONDANT

(43) Date of publication of application: 30.12.2020
(73) Proprietor: Valeo eAutomotive Germany GmbH, 91056 Erlangen (DE)
(72) Inventor: Rayya, Monzer, 90431 Nürnberg (DE); Huck, Fabian, 90425 Nürnberg (DE); Trodler, Dirk, 91227 Leinburg (DE)

(56) References cited:
- DE-A1- 102015 212 721
- JP-A- 2012 069 892
- US-A1- 2010 172 091
- US-A1- 2017 170 097

## Description

The present invention relates to a power inverter device. Besides, the present invention relates to an arrangement and a method for operating a power inverter device or an arrangement.

DE 10 2015 212721 A1 discloses an inverter comprising a power output stage and a cooling device for a power semiconductor comprising a power module for each phase of the inverter. The cooling device comprises a clearance for guiding a fluid stream along a flow axis and comprises a heat contact wall and a ceiling wall being opposite thereto, wherein the power semiconductor are arranged a side of the heat contact wall opposite to a side of the heat contact wall that faces the clearance. A height of the clearance between the heat contact wall and the ceiling wall decreases along the flow axis.

Further power inverter devices are disclosed by JP 2012 069892 A1 and US 2010/172091 A1.

Due to a significant power loss in semiconductor switching element arrangements, highly utilized power inverter devices are provided with a liquid cooling. Thereto, a coolant flows from an inlet channel through a cooling channel into an outlet channel, wherein the semiconductor switching element arrangements are mounted in a row and a mounting direction corresponds to a flow direction of the coolant. As the coolant becomes warmer while passing the cooling channel, an outlet-side semiconductor switching element arrangement with respect to the flow direction is less cooled than an inlet-side semiconductor switching element arrangement. Consequently, the heat distribution among the semiconductor switching element arrangements is highly unbalanced along the mounting direction.

It is an object of the present invention to provide an improved possibility for cooling semiconductor switching element arrangements in a power inverter device.

According to the invention this object is solved by the power inverter device according to claim 1. Preferred embodiments are defined in the dependent claims.

The invention aims to increase a heat transfer from an outlet-side semiconductor switching element arrangement to the coolant and to adjust the cooling channel geometry with respect to pressure drop constraints by changing the mean or average cross-sectional area of the main sections. Different physical effects for achieving this aim are described in more detail with respect to several embodiments of the present invention. Advantageously, increasing the heat dissipation of the outlet-side semiconductor switching element arrangement results in a more balanced heat transfer along the mounting direction and increases cooling efficiency of the cooling device.

In view of the use case of the power inverter device to provide an three-phase AC current it is preferred that the cooling channel has a third main section extending underneath a third semiconductor switching element arrangement along the mounting direction and having a mean cross-sectional area with respect to a plane being perpendicular to the mounting direction, wherein the third semiconductor switching element arrangement is arranged between the first semiconductor switching element arrangement and the second semiconductor switching element arrangement, wherein a mean cross-sectional area of the third main section is smaller than the mean cross-sectional area of the first main section and larger than the mean cross-sectional area of the second main section.

Alternatively, the first main section extends underneath a third semiconductor switching element arrangement being arranged between the first semiconductor switching element arrangement and the second semiconductor switching element arrangement.

According to the invention, the cooling channel comprises at least one connection section that connects adjacent main sections and has a bottom side. According to the invention, the bottom side has the shape of a step or a slope. Furthermore, a side wall or opposing side walls extending from the bottom side and forming a boundary of the cooling channel along the mounting direction has the shape of a step. The step-shape of the bottom side or a respective side wall realizes the change of the mean cross-sectional area between the adjacent main sections. Therein, the step may be radius or right-angled. According to a preferred embodiment, each main section has a bottom side. Typically, the bottom side extends in parallel to a plane defined by a contact area between the semiconductor switching element arrangements and the cooling device. Therein, the bottom side may be flat. Alternatively or additionally, a side wall or opposing side walls extending from the bottom side and forming a boundary of the cooling channel along the mounting direction may be flat. According to an alternative embodiment, each main section comprises a plurality of subsections along the mounting direction, wherein a mean cross-sectional area of adjacent subsection becomes smaller with respect to the direction from the first end of the cooling channel to the second end of the cooling channel. Therein, the bottom side and/or a side wall of each main section may have a linearly rising or falling profile along the mounting direction. Alternatively, the profile may be curved. In this embodiment it is preferred that adjacent main sections abut each other. With respect to the power inverter device according to the invention the first main section may extend from the first end of the cooling channel into the direction of the second end. Thus, the first main section is the inlet-side main section and the respective mean cross-sectional area becomes smaller along the mounting direction. This causes of the coolant to have a higher flow velocity underneath the outlet-side semiconductor switching element arrangement. The higher flow velocity causes a higher heat dissipation.

Alternatively, the first main section may extend from the second end of the cooling channel into the direction of the first end. Thus, the first main section is the outlet-side main section and, in general, the mean cross-sectional area becomes larger from the inlet-side along the mounting direction. Such a structure causes a flow expansion that resolves and absorbs a thermal boundary layer of coolant. By changing the mean cross-sectional area turbulences are induced that increase the heat dissipation at the outlet-side of the cooling channel. In this case, it is highly preferred that the connection section between adjacent main sections has a step shape as described afore for generating an abrupt flow expansion.

Preferably, projections for enlarging a heat transfer surface are provided on a bottom side and/or a side wall of the cooling channel. The projections may be knob- or triangle-shaped.

Advantageously, the inlet channel and/or the outlet channel is inclined with respect to the cooling channel.

Preferably, the cooling channel is formed by a cavity within a housing element and by a base plate closing the cavity, wherein the semiconductor switching element arrangements are mounted on the base plate.

For increasing the cooling efficiency of the power inverter device even more, the cooling channel side of the base plate may be provided with ribbon bonds. Alternatively, for reducing manufacturing effort of the cooling device the cooling channel side of the base plate may be flat.

According to the present invention the above object is furthermore solved by an arrangement with a power inverter device according to the invention and an electric machine, wherein the power inverter device is configured to supply the electric machine.

According to the present invention the above object is furthermore solved by a method according to claim 15. All statements regarding the power inverter device according to the invention may apply analogously to the method according to the invention so that advantages described with respect to the power inverter device may be achieved by the method as well.

Further details and advantages of the present invention are disclosed in the following embodiments. Therein, reference is made to the drawings, which show schematically:
- Fig. 1: a block diagram of an embodiment of the arrangement according to the invention comprising a first embodiment of the power inverter device according to the present invention;
- Fig. 2: a top-side view on the power inverter device shown in Fig. 1;
- Fig. 3: a cross-sectional view of the power inverter device shown in Fig. 1;
- Fig. 4: a detailed view of a section IV shown in Fig. 3;
- Fig. 5 to 11: each a principle drawing of a cross-sectional view of a cooling channel structure, Figs. 6 and 7 are not forming part of the invention; and
- Fig. 12: a top-side view of a cooling channel structure according to a further embodiment of the invention.

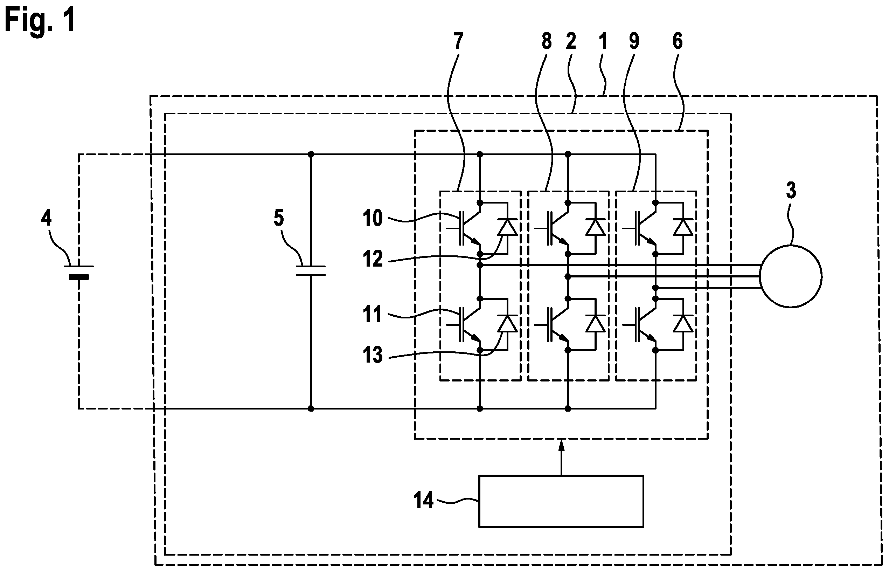

Fig. 1 is a block diagram of an embodiment of an arrangement 1 with a power inverter device 2 and an electric machine 3, wherein the power inverter device 2 is configured to supply the electric machine 3. The electric machine 3 is suitable for driving the vehicle such as a battery electric vehicle or a hybrid electric vehicle. Furthermore, Fig. 1 shows a high-voltage battery 4 connected to a DC link of the power inverter device 2 or to the arrangement 1, respectively.

The power inverter device 2 comprises a DC link capacitor 5, and a semiconductor switching element module 6 having a first semiconductor switching element arrangement 7, a second semiconductor switching element arrangement 8 and a third semiconductor switching element arrangement 9. Each semiconductor switching element arrangement 7, 8, 9 is configured to provide an output phase current of the power inverter device 2. Thereto, each semiconductor switching element arrangement 7, 8, 9 comprises a half-bridge formed by two insulated gate bipolar transistors (IGBT) 10, 11 and an antiparallel diode 12, 13 for each IGBT 10, 11. Alternatively, the half-bridges may be formed by Power-MOSFET. Furthermore, the power inverter device 2 comprises a control unit 14 being configured to control the semiconductor switching element module 6 or the semiconductor switching element arrangements 7, 8, 9, respectively, so as to provide a three-phase output voltage.

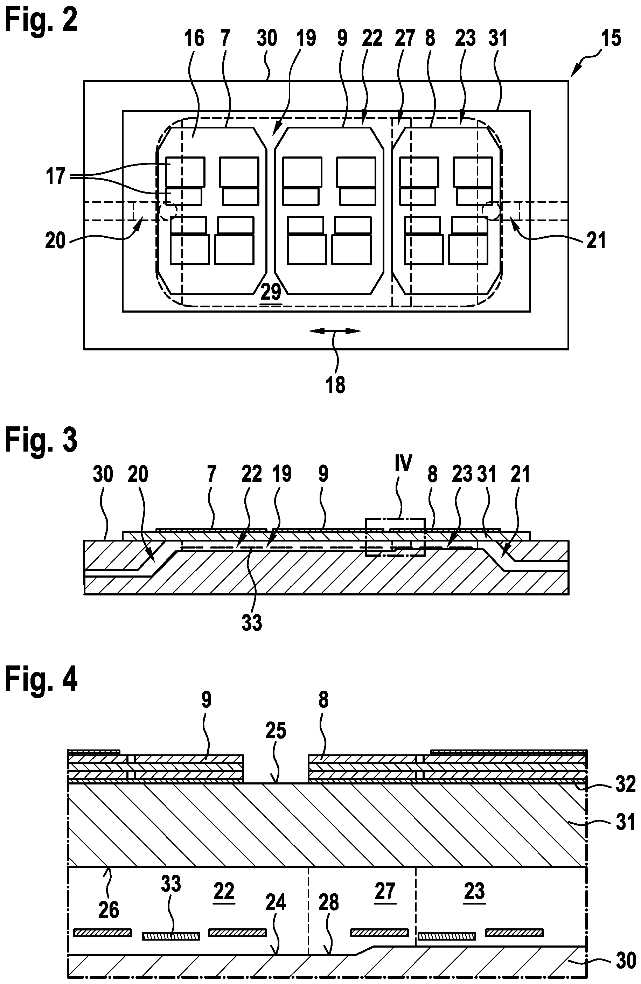

Fig. 2 to Fig. 4 show the semiconductor switching element arrangement 7, 8, 9 being mounted on a cooling device 15, wherein Fig. 2 is a top-side view, Fig. 3 is a cross-sectional view and Fig. 4 is a detailed view of a section IV depicted in Fig. 3.

Each semiconductor switching element arrangement 7, 8, 9 comprises a substrate 16, on which semiconductor chips 17 are arranged. In particular, these semiconductor chips 17 realize the IGBT 10, 11 and diodes 12, 13. The semiconductor switching element arrangements 7, 8, 9 are mounted in a row extending along a mounting direction 18 on the cooling device 15.

The cooling device 15 comprises a cooling channel 19 for cooling the semiconductor switching element arrangements 7, 8, 9 and being configured so as to allow a coolant to flow along the mounting direction 18. Furthermore, the cooling device 15 comprises an inlet channel 20 that is connected to a first end of the cooling channel 19 and an outlet channel 21 that is connected to a second end of the cooling channel 19. Thus, a flow orientation of the coolant is oriented from the inlet channel 20 to the outlet channel 21 or from the first end of the cooling channel 19 to the second end of the cooling channel 19, respectively.

The cooling channel 19 has a first main section 22 extending from the first end, that is the inlet-side end, underneath the first semiconductor switching element arrangement 7 and the third semiconductor switching element arrangement 9 along the mounting direction 18. A second main section 23 of the cooling channel 19 extends from the second end, that is the outlet-side end, underneath the second semiconductor switching element arrangement 8 along the mounting direction 18. Therein, a mean cross-sectional area with respect to a plane being perpendicular to the mounting direction 18 of the second main section 23 is smaller than a correspondingly defined mean cross-sectional area of the first main section 22. As respective bottom sides 24 of the main sections 22, 23 are flat and arranged in parallel to a contact area 25 between the semiconductor switching element arrangements 7, 8, 9 and the cooling device 15, the change of the respective mean cross-sectional areas is realized by a change of a distance between a respective bottom side 24 of the main sections 22, 23 and a top side 26 of the cooling channel 19.

Thereto, the cooling channel 19 comprises a connection section 27 that connects the adjacent main sections 22, 23. A bottom side 28 of the connection section 27 has the shape of a slope in order to reduce the mean cross-sectional area of the second main section 23 with respect to the first main section 22. The reduction of the mean cross-sectional area of the main sections 22, 23 between the inlet channel 22 and the outlet channel 21 causes the coolant to flow faster within the second main section 23 than within the first main section 22.

As the coolant becomes warmer when flowing though the cooling channel 19, it has already notably warmed up when entering the second main section 23. However, as the heat dissipation in the second main section 23 is increased by the higher flow velocity, the overall heat dissipation is more balanced in comparison to a conventional cooling device having a uniform cross-sectional area along the cooling channel.

As can be seen best in Fig. 2 the cooling channel 19 is formed by a cavity 29 within a housing element 30 and by a base plate 31 closing the cavity 29. The semiconductor switching element arrangements 7, 8, 9 are mounted on the base plate 31 by means of a soldering layer 32. A cooling-channel-side of the base plate 31 is provided with ribbon bonds 33 that increase the cooling efficiency of the cooling device 15. Alternatively, the base plate 31 may be entirely flat all over the mounting direction 18.

As can be seen best in Fig. 3 the inlet channel 20 and the outlet channel 21 can be inclined with respect to the cooling channel 19.

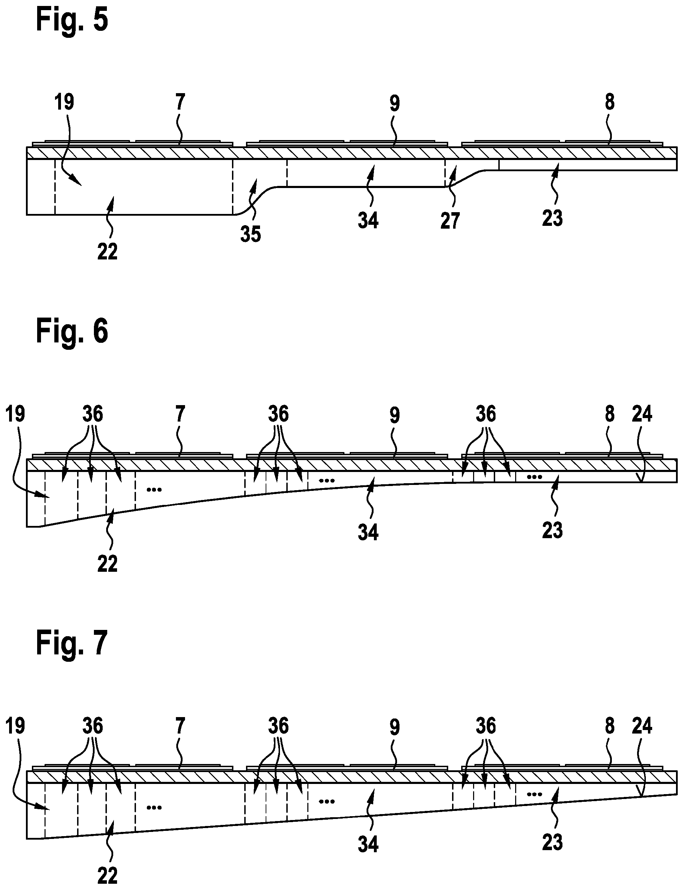

Fig. 5 to Fig. 11 are each a principle drawing of a cross-sectional view of a cooling channel 19 structure of the power inverter device (Figs. 6 and 7 do not form part of the present invention). Therein, only a respective cooling channel structure is depicted and the inlet channels 20, 21 are omitted. As far as nothing else is mentioned, all statements referring the first embodiment apply analogously to the further embodiments, wherein identical reference signs are used for identical or equivalent components. Note that the principle drawings may not show the cooling channel structure true to scale in order emphasize differences between the respective embodiments.

According to the embodiment shown in Fig. 5 the cooling channel 19 has a third main section extending underneath the third semiconductor switching element arrangement 9 along the mounting direction 18. Therein, the mean cross-sectional area of the third main section 32 is smaller than the mean cross-sectional area of the first main section 22 and larger than the mean cross-sectional area of the second main section 23. The connection section 27 connects the third main section 34 and the second main section 23 and a further connection section 25 connects the first main channel 22 and the third main channel 34. Both connection sections 27, 35 have the form of a slope. In the present embodiment different flow velocities are caused in all three main sections 22, 23, 34.

According to the examples shown in Fig. 6 and Fig. 7 (not forming part of the present invention) the main sections 22, 23, 34 abut each other and each main section 22, 23, 34 comprises a plurality of subsections 36. Therein, mean cross-sectional areas of adjacent subsections 36 become smaller with respect to the direction from the first end of the cooling channel 19 to the second end of the cooling channel 19.

According to the example depicted in Fig. 6 the bottom side 24 of each main section 22, 23, 34, and particularly a corresponding bottom side of the whole cooling channel 19, has a curved profile. According to the example depicted in Fig. 7 the respective bottom sides 24, and particularly a corresponding bottom side of the whole cooling channel 19, have the linearly rising profile. In both examples, the flow velocity increases continuously along the mounting direction 18.

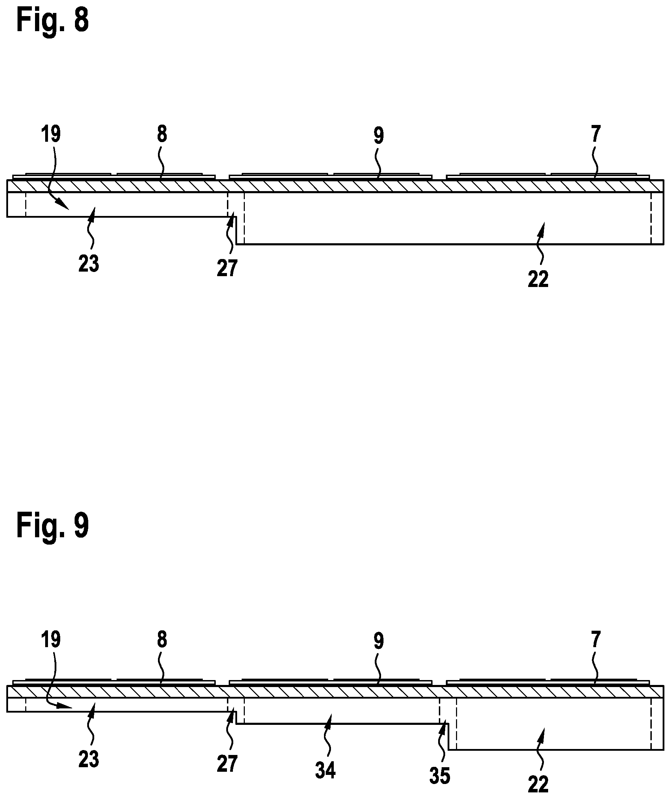

The embodiment according to Fig. 8 corresponds to the first embodiment, however, the first semiconductor switching element arrangement 7 and the first main section 22 are arranged at the second end of the cooling channel 19, that is the outlet-side end of the cooling channel 19, whereas the second semiconductor switching element arrangement 8 and the second main section 23 are arranged at an inlet-side of the cooling channel 19. Note that the mean cross-sectional area of the second main section 23 is still smaller than the one of the first main section 22. Furthermore, the connection section 27 connecting the second main channel 23 and the first main channel 22 has the shape of a right-angled step. Alternatively, the step may be radiused.

According to the cooling channel structure depicted in Fig. 8 the mean cross-sectional area along the cooling channel 19 becomes suddenly larger with respect to the flow orientation of the coolant. This causes a sudden flow expansion that resolves and absorbs a thermal boundary layer of the coolant and induces turbulences which increase the heat dissipation within the first main section 22.

The embodiment according to Fig. 9 corresponds to the one depicted in Fig. 8, wherein the third main section 34 extending underneath the third semiconductor switching element arrangement 9 is provided. The mean cross-sectional area of the third main section 33 is smaller than the one of the first main section 22 and larger than the one of the second main section 23. In this embodiment the connection section 27 connects the second main section 23 and the third main section 34 and a further connection section 35 connects the third main section 34 and the first main section 22. The connection section 35 has the shape of a right-angled step or, alternatively, a radiused step.

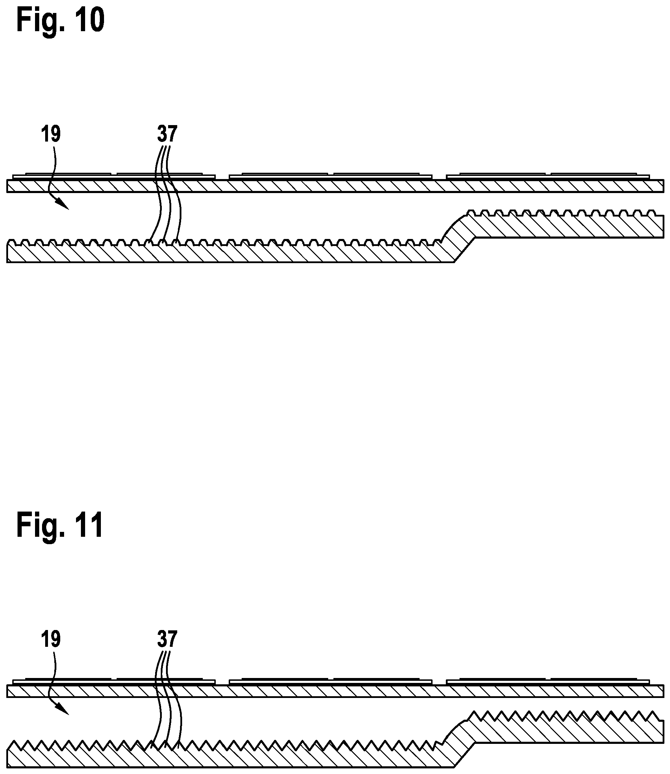

The embodiments depicted in Fig. 10 and Fig. 11 correspond to the first embodiment, wherein projections 37 for enlarging a heat transfer surface between the coolant and the housing element 30 are provided on the bottom side of the cooling channel 19.

According to the embodiment of Fig. 10 the projections 37 are knob-shaped, whereas the projections depicted in Fig. 11 are triangle-shaped. Note that the projections 37 may be correspondingly applied to the embodiments according to Fig. 5 to Fig. 9 as well.

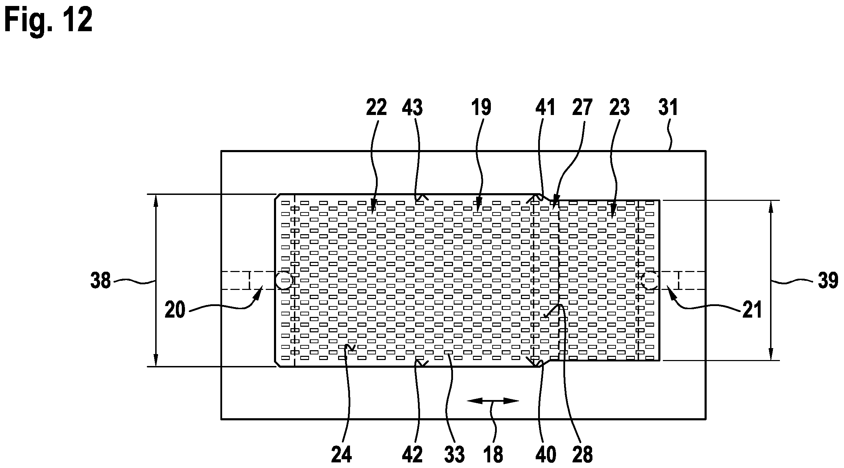

Fig. 12 is a top-side view of a further embodiment of a cooling channel 19 according to a further embodiment of the power inverter device 2, further depicting the base plate 31 and a distribution of the ribbon bonds 33.

In this embodiment the reduction of the mean cross-sectional area of the main sections 22, 23 between the inlet channel 20 and the outlet channel 21 is realized by providing the second main section 23 with a smaller width 39 than a width 28 of the first main section 22. Thereto, a first side wall 40 of the connection section 27 and a second side wall 41 of the connection section 27, each extending from the bottom side 28 and forming a boundary of the cooling channel 19 along the mounting direction 18, have the form of a slope. Furthermore, a first side wall 42 and an second side wall 43 of each main section 22, 23 are flat.

According to further embodiments in order to change the mean cross-sectional are, the side walls 40 to 43 may be shaped correspondingly to the bottom sides 24, 28 as describes with respect to the afore-mentioned embodiments.

## Claims

1. Power inverter device (2), comprising a plurality of semiconductor switching element arrangements (7, 8, 9) each configured to provide an output phase current of the power inverter device (2), and a cooling device (15), on which the semiconductor switching element arrangements (7, 8, 9) are mounted in a row extending along a mounting direction (18), the cooling device (15) comprising
- a cooling channel (19) being configured so as to allow a coolant to flow along the mounting direction (18),
- an inlet channel (20) that is connected to a first end of the cooling channel (19), and
- an outlet channel (21) that is connected to a second end of the cooling channel (19),
wherein the cooling channel (19) has
- a first main section (22) extending from one end of the cooling channel (19) underneath a first semiconductor switching element arrangement (7) along the mounting direction (18) and having a mean cross-sectional area with respect to a plane being perpendicular to the mounting direction (18), and
- a second main section (23) extending from the other end of the cooling channel (19) underneath a second semiconductor switching element arrangement (8) along the mounting direction (18) and having a mean cross-sectional area with respect to a plane being perpendicular to the mounting direction (18) that is smaller than the mean cross-sectional area of the first main section (22) wherein the cooling channel (19) comprises at least one connection section (27, 35) that connects adjacent main sections (22, 23, 34) **characterized in that** the at least one connection section has a bottom side (28) having the shape of a step.

2. Power inverter device according to claim 1, wherein
the cooling channel (19) has a third main section (34) extending underneath a third semiconductor switching element arrangement (9) along the mounting direction (18) and having a mean cross-sectional area with respect to a plane being perpendicular to the mounting direction (18), wherein the third semiconductor switching element arrangement (9) is arranged between the first semiconductor switching element arrangement (7) and the second semiconductor switching element arrangement (8), wherein a mean cross-sectional area of the third main section (34) is smaller than the mean cross-sectional area of the first main section (22) and larger than the mean cross-sectional area of the second main section (23).

3. Power inverter device according to claim 1, wherein
the first main section (22) extends underneath a third semiconductor switching element arrangement (9) being arranged between the first semiconductor switching element arrangement (7) and the second semiconductor switching element arrangement (8).

4. Power inverter device according to any of the preceding claims, wherein a side wall or opposite side walls extending from the bottom side (28) and forming a boundary of the cooling channel (19) along the mounting direction (18) has or have the shape of a step or a slope.

5. Power inverter device according to any of the preceding claims, wherein the step is radiused or right-angled.

6. Power inverter device according to any of the preceding claims, wherein each main section (22, 23, 34) has a bottom side (24), wherein
- the bottom side (24) of the main section (22, 23, 34) and/or
- a side wall or opposite side walls extending from the bottom side (24) of the main section (22, 23, 34) and forming a boundary of the cooling channel (19) along the mounting direction (18)
is or are flat.

7. Power inverter device according to any of claims 1 to 5, wherein
each main section (22, 23, 34) comprises a plurality of subsections (36) along the mounting direction (18), wherein a mean cross-sectional area of adjacent subsection (36) becomes smaller with respect to the direction from the first end of the cooling channel to the second end of the cooling channel.

8. Power inverter device according to any of the preceding claims, wherein the first main section (22) extends from the first end of the cooling channel (19) into the direction of the second end.

9. Power inverter device according to any of claims 1 to 7, wherein
the first main section (22) extends from the second end of the cooling channel (19) into the direction of the first end.

10. Power inverter device according to any of the preceding claims, wherein projections (37) for enlarging a heat transfer surface are provided on a bottom side and/or a side wall of the cooling channel (19).

11. Power inverter device according to any of the preceding claims, wherein the inlet channel (20) and/or the outlet channel (21) is inclined with respect to the cooling channel (19).

12. Power inverter device according to any of the preceding claims, wherein the cooling channel (19) is formed by a cavity (29) within a housing element (30) and by a base plate (31) closing the cavity (29), wherein the semiconductor switching element arrangements (7, 8, 9) are mounted on the base plate (31).

13. Power inverter device according to claim 12, wherein
a cooling-channel-side of the base plate (31) is flat or provided with ribbon bonds (33).

14. Arrangement (1) with a power inverter device (2) according to any of the preceding claims and an electric machine (3), wherein the power inverter device (2) is configured to supply the electric machine (3).

15. Method for operating a power inverter device (2) according to any of claims 1 to 13 or an arrangement (1) according to claim 14, wherein the coolant is pumped so as to flow from the inlet channel (20) through the cooling channel (19) into the outlet channel (21).

## Patentansprüche

1. Wechselrichtervorrichtung (2), umfassend eine Mehrzahl von Halbleiterschaltelementanordnungen (7, 8, 9), die jeweils dafür konfiguriert sind, einen Ausgangsphasenstrom der Wechselrichtervorrichtung (2) bereitzustellen, und eine Kühlvorrichtung (15), auf der die Halbleiterschaltelementanordnungen (7, 8, 9) in einer sich entlang einer Montagerichtung (18) erstreckenden Reihe montiert sind, wobei die Kühlvorrichtung (15) Folgendes umfasst:
- einen Kühlkanal (19), der so konfiguriert ist, dass ein Kühlmittel entlang der Montagerichtung (18) strömen kann,
- einen Einlasskanal (20), der mit einem ersten Ende des Kühlkanals (19) verbunden ist, und
- einen Auslasskanal (21), der mit einem zweiten Ende des Kühlkanals (19) verbunden ist, wobei der Kühlkanal (19) Folgendes aufweist:
- einen ersten Hauptabschnitt (22), der sich von einem Ende des Kühlkanals (19) unterhalb einer ersten Halbleiterschaltelementanordnung (7) entlang der Montagerichtung (18) erstreckt und eine mittlere Querschnittsfläche in Bezug auf eine Ebene senkrecht zur Montagerichtung (18) aufweist, und
- einen zweiten Hauptabschnitt (23), der sich vom anderen Ende des Kühlkanals (19) unterhalb einer zweiten Halbleiterschaltelementanordnung (8) entlang der Montagerichtung (18) erstreckt und eine mittlere Querschnittsfläche in Bezug auf eine Ebene senkrecht zur Montagerichtung (18) aufweist, die kleiner ist als die mittlere Querschnittsfläche des ersten Hauptabschnitts (22),
wobei der Kühlkanal (19) mindestens einen Verbindungsabschnitt (27, 35) umfasst, der benachbarte Hauptabschnitte (22, 23, 34) verbindet, **dadurch gekennzeichnet, dass** der mindestens eine Verbindungsabschnitt eine Unterseite (28) aufweist, die die Form einer Stufe hat.

2. Wechselrichtervorrichtung nach Anspruch 1, wobei der Kühlkanal (19) einen dritten Hauptabschnitt (34) aufweist, der sich unterhalb einer dritten Halbleiterschaltelementanordnung (9) entlang der Montagerichtung (18) erstreckt und eine mittlere Querschnittsfläche in Bezug auf eine Ebene senkrecht zur Montagerichtung (18) aufweist, wobei die dritte Halbleiterschaltelementanordnung (9) zwischen der ersten Halbleiterschaltelementanordnung (7) und der zweiten Halbleiterschaltelementanordnung (8) angeordnet ist, wobei eine mittlere Querschnittsfläche des dritten Hauptabschnitts (34) kleiner ist als die mittlere Querschnittsfläche des ersten Hauptabschnitts (22) und größer ist als die mittlere Querschnittsfläche des zweiten Hauptabschnitts (23).

3. Wechselrichtervorrichtung nach Anspruch 1, wobei sich der erste Hauptabschnitt (22) unterhalb einer dritten Halbleiterschaltelementanordnung (9) erstreckt, die zwischen der ersten Halbleiterschaltelementanordnung (7) und der zweiten Halbleiterschaltelementanordnung (8) angeordnet ist.

4. Wechselrichtervorrichtung nach einem der vorhergehenden Ansprüche, wobei eine Seitenwand oder gegenüberliegende Seitenwände, die sich von der Unterseite (28) aus erstrecken und eine Begrenzung des Kühlkanals (19) entlang der Montagerichtung (18) bilden, die Form einer Stufe oder einer Schräge aufweisen.

5. Wechselrichtervorrichtung nach einem der vorhergehenden Ansprüche, wobei die Stufe abgerundet oder rechtwinklig ist.

6. Wechselrichtervorrichtung nach einem der vorhergehenden Ansprüche, wobei jeder Hauptabschnitt (22, 23, 34) eine Unterseite (24) aufweist, wobei
- die Unterseite (24) des Hauptabschnitts (22, 23, 34) und/oder
- eine Seitenwand oder gegenüberliegende Seitenwände, die sich von der Unterseite (24) des Hauptabschnitts (22, 23, 34) aus erstrecken und eine Begrenzung des Kühlkanals (19) entlang der Montagerichtung (18) bilden, flach ist oder sind.

7. Wechselrichtervorrichtung nach einem der Ansprüche 1 bis 5, wobei jeder Hauptabschnitt (22, 23, 34) eine Mehrzahl von Teilabschnitten (36) entlang der Montagerichtung (18) umfasst, wobei eine mittlere Querschnittsfläche benachbarter Teilabschnitte (36) in Bezug auf die Richtung vom ersten Ende des Kühlkanals zum zweiten Ende des Kühlkanals kleiner wird.

8. Wechselrichtervorrichtung nach einem der vorhergehenden Ansprüche, wobei sich der erste Hauptabschnitt (22) vom ersten Ende des Kühlkanals (19) in Richtung des zweiten Endes erstreckt.

9. Wechselrichtervorrichtung nach einem der Ansprüche 1 bis 7, wobei sich der erste Hauptabschnitt (22) vom zweiten Ende des Kühlkanals (19) in Richtung des ersten Endes erstreckt.

10. Wechselrichtervorrichtung nach einem der vorhergehenden Ansprüche, wobei Vorsprünge (37) zur Vergrößerung einer Wärmeübertragungsfläche an einer Unterseite und/oder einer Seitenwand des Kühlkanals (19) vorgesehen sind.

11. Wechselrichtervorrichtung nach einem der vorhergehenden Ansprüche, wobei der Einlasskanal (20) und/oder der Auslasskanal (21) in Bezug auf den Kühlkanal (19) geneigt ist.

12. Wechselrichtervorrichtung nach einem der vorhergehenden Ansprüche, wobei der Kühlkanal (19) durch einen Hohlraum (29) innerhalb eines Gehäuseelements (30) und durch eine den Hohlraum (29) verschließende Grundplatte (31) gebildet ist, wobei die Halbleiterschaltelementanordnungen (7, 8, 9) auf der Grundplatte (31) montiert sind.

13. Wechselrichtervorrichtung nach Anspruch 12, wobei eine kühlkanalseitige Seite der Grundplatte (31) flach ist oder mit Bondbändchen (33) versehen ist.

14. Anordnung (1) mit einer Wechselrichtervorrichtung (2) nach einem der vorhergehenden Ansprüche und einer elektrischen Maschine (3), wobei die Wechselrichtervorrichtung (2) dafür konfiguriert ist, die elektrische Maschine (3) zu versorgen.

15. Verfahren zum Betreiben einer Wechselrichtervorrichtung (2) nach einem der Ansprüche 1 bis 13 oder einer Anordnung (1) nach Anspruch 14, wobei das Kühlmittel so gepumpt wird, dass es vom Einlasskanal (20) durch den Kühlkanal (19) in den Auslasskanal (21) strömt.

## Revendications

1. Dispositif onduleur de puissance (2), comprenant une pluralité d'agencements d'éléments de commutation à semi-conducteur (7, 8, 9) configurés chacun pour fournir un courant de phase de sortie du dispositif onduleur de puissance (2), et un dispositif de refroidissement (15), sur lequel les agencements d'éléments de commutation à semi-conducteur (7, 8, 9) sont montés en une rangée s'étendant le long d'une direction de montage (18), le dispositif de refroidissement (15) comprenant :
- un canal de refroidissement (19) configuré de manière à permettre à un fluide de refroidissement de s'écouler le long de la direction de montage (18),
- un canal d'entrée (20) qui est relié à une première extrémité du canal de refroidissement (19), et
- un canal de sortie (21) qui est relié à une seconde extrémité du canal de refroidissement (19),
dans lequel le canal de refroidissement (19) présente :
- une première section principale (22) s'étendant depuis une extrémité du canal de refroidissement (19) en dessous d'un premier agencement d'élément de commutation à semi-conducteur (7) le long de la direction de montage (18) et ayant une aire de section transversale moyenne par rapport à un plan perpendiculaire à la direction de montage (18), et
- une deuxième section principale (23) s'étendant depuis l'autre extrémité du canal de refroidissement (19) en dessous d'un deuxième agencement d'élément de commutation à semi-conducteur (8) le long de la direction de montage (18) et ayant une aire de section transversale moyenne par rapport à un plan perpendiculaire à la direction de montage (18) qui est inférieure à l'aire de section transversale moyenne de la première section principale (22),
dans lequel le canal de refroidissement (19) comprend au moins une section de connexion (27, 35) qui relie des sections principales adjacentes (22, 23, 34), **caractérisé en ce que** ladite au moins une section de connexion présente un côté inférieur (28) ayant la forme d'une marche.

2. Dispositif onduleur de puissance selon la revendication 1, dans lequel le canal de refroidissement (19) présente une troisième section principale (34) s'étendant en dessous d'un troisième agencement d'élément de commutation à semi-conducteur (9) le long de la direction de montage (18) et ayant une aire de section transversale moyenne par rapport à un plan perpendiculaire à la direction de montage (18), dans lequel le troisième agencement d'élément de commutation à semi-conducteur (9) est agencé entre le premier agencement d'élément de commutation à semi-conducteur (7) et le deuxième agencement d'élément de commutation à semi-conducteur (8), dans lequel une aire de section transversale moyenne de la troisième section principale (34) est inférieure à l'aire de section transversale moyenne de la première section principale (22) et supérieure à l'aire de section transversale moyenne de la deuxième section principale (23).

3. Dispositif onduleur de puissance selon la revendication 1, dans lequel la première section principale (22) s'étend en dessous d'un troisième agencement d'élément de commutation à semi-conducteur (9) agencé entre le premier agencement d'élément de commutation à semi-conducteur (7) et le deuxième agencement d'élément de commutation à semi-conducteur (8).

4. Dispositif onduleur de puissance selon l'une quelconque des revendications précédentes, dans lequel une paroi latérale ou des parois latérales opposées s'étendant depuis le côté inférieur (28) et formant une limite du canal de refroidissement (19) le long de la direction de montage (18) a ou ont la forme d'une marche ou d'une pente.

5. Dispositif onduleur de puissance selon l'une quelconque des revendications précédentes, dans lequel la marche est arrondie ou à angle droit.

6. Dispositif onduleur de puissance selon l'une quelconque des revendications précédentes, dans lequel chaque section principale (22, 23, 34) présente un côté inférieur (24), dans lequel
- le côté inférieur (24) de la section principale (22, 23, 34) et/ou
- une paroi latérale ou des parois latérales opposées s'étendant depuis le côté inférieur (24) de la section principale (22, 23, 34) et formant une limite du canal de refroidissement (19) le long de la direction de montage (18) est ou sont plat(s).

7. Dispositif onduleur de puissance selon l'une quelconque des revendications 1 à 5, dans lequel chaque section principale (22, 23, 34) comprend une pluralité de sous-sections (36) le long de la direction de montage (18), dans lequel une aire de section transversale moyenne de sous-sections (36) adjacentes devient plus petite par rapport à la direction allant de la première extrémité du canal de refroidissement vers la seconde extrémité du canal de refroidissement.

8. Dispositif onduleur de puissance selon l'une quelconque des revendications précédentes, dans lequel la première section principale (22) s'étend depuis la première extrémité du canal de refroidissement (19) en direction de la seconde extrémité.

9. Dispositif onduleur de puissance selon l'une quelconque des revendications 1 à 7, dans lequel la première section principale (22) s'étend depuis la seconde extrémité du canal de refroidissement (19) en direction de la première extrémité.

10. Dispositif onduleur de puissance selon l'une quelconque des revendications précédentes, dans lequel des saillies (37) destinées à agrandir une surface de transfert de chaleur sont prévues sur un côté inférieur et/ou une paroi latérale du canal de refroidissement (19).

11. Dispositif onduleur de puissance selon l'une quelconque des revendications précédentes, dans lequel le canal d'entrée (20) et/ou le canal de sortie (21) est ou sont incliné(s) par rapport au canal de refroidissement (19).

12. Dispositif onduleur de puissance selon l'une quelconque des revendications précédentes, dans lequel le canal de refroidissement (19) est formé par une cavité (29) à l'intérieur d'un élément de boîtier (30) et par une plaque de base (31) fermant la cavité (29), dans lequel les agencements d'éléments de commutation à semi-conducteur (7, 8, 9) sont montés sur la plaque de base (31).

13. Dispositif onduleur de puissance selon la revendication 12, dans lequel un côté de la plaque de base (31) situé du côté du canal de refroidissement est plat ou pourvu de connexions par ruban (33).

14. Agencement (1) comprenant un dispositif onduleur de puissance (2) selon l'une quelconque des revendications précédentes et une machine électrique (3), dans lequel le dispositif onduleur de puissance (2) est configuré pour alimenter la machine électrique (3).

15. Procédé de fonctionnement d'un dispositif onduleur de puissance (2) selon l'une quelconque des revendications 1 à 13 ou d'un agencement (1) selon la revendication 14, dans lequel le fluide de refroidissement est pompé de manière à s'écouler depuis le canal d'entrée (20) à travers le canal de refroidissement (19) dans le canal de sortie (21).
